# EUROPÄISCHE PATENTSCHRIFT

(11) **EP 1 344 436 B1**
(45) Veröffentlichungstag und Bekanntmachung des Hinweises auf die Patenterteilung: **18.05.2005**
(21) Anmeldenummer: 01271797.1
(22) Anmeldetag: 10.12.2001
(51) Int. Cl.: H05K 7/12

(54) **MONTAGEMITTEL FÜR ZWEI EINZELTEILE EINES GERÄTES**
ASSEMBLY ELEMENT FOR TWO COMPONENT PARTS OF A DEVICE
DISPOSITIF DE MONTAGE POUR DEUX PIECES CONSTITUTIVES D'UN APPAREIL

(30) Priorität: 18.12.2000 DE 10063085
(43) Veröffentlichungstag der Anmeldung: 17.09.2003
(73) Patentinhaber: SIEMENS AKTIENGESELLSCHAFT, 80333 München (DE)
(72) Erfinder: KAUTZ, Stefan, 90607 Rückersdorf (DE); ZEININGER, Heinz, 90587 Obermichelbach (DE)
(86) Internationale Anmeldenummer: PCT/DE2001/004640
(87) Internationale Veröffentlichungsnummer: WO 2002/051225

(56) Entgegenhaltungen:
- GB-A- 2 217 451
- US-A- 5 176 884
- US-A- 5 553 766

## Beschreibung

Die Erfindung bezieht sich auf ein Montagemittel für zwei Einzelteile eines Gerätes, wobei das Montagemittel zumindest im montierten Zustand des Gerätes formschlüssig mit den beiden Geräteeinzelteilen verbunden ist.

Bekannte Montagemittel, mit denen sich insbesondere eine formschlüssige und gegebenenfalls auch kraftschlüssige Verbindung zwischen zwei Einzelteilen eines Gerätes herstellen lassen, sind beispielsweise Schrauben, Nieten oder Klemmen.

Die zunehmende Integrationsdichte bei der Entwicklung von Bauelementen und Bestückungstechnologien insbesondere auf dem Gebiet der Halbleiterelektronik führt zu immer leistungsfähigeren, kleineren und leichteren Baugruppen bzw. entsprechenden Geräten. Neben hohen Qualitätsanforderungen an die Konstruktion solcher Geräte sollen die Gerätefertigung und -montage aus Kostengründen möglichst automatisiert erfolgen. Dabei steht ein Produktdesign mit zunehmender Miniaturisierung vor dem Problem, dass der verfügbare Platz für die Montage- und Verbindungstechnik der Einzelteile dieser Geräte immer geringer wird bzw. die Verbindungsstellen immer schwieriger zugänglich sind.

Außerdem sind die Hersteller bestimmter Geräte durch die Gesetzgebung vielfach gezwungen, Altgeräte zurückzunehmen und Einrichtungen für die Behandlung bzw. Verarbeitung von Altgeräten zu schaffen. Aus Kostengründen müssen deshalb die Geräte einfach demontierbar sein.

Da bisher die Hersteller vieler Geräte noch nicht zur Rücknahme von Altgeräten verpflichtet sind, wurden Anforderungen an eine Demontage von deren Einzelteilen nur im geringen Umfang in eine Produktentwicklung einbezogen. Insbesondere die Technologien für Schaltungsträger/-bestückung sind im Umbruch; Produktentwicklungen bauen in zunehmendem Masse auf den innovativen und hochintegrierten Technologien wie "Flip chip"-, "Ball grid-Arrays"-, "All layers interconnected via holes"-Technologien usw. auf. Bei solchen neuen Technologien werden hohe Integrationsdichten angestrebt; das hat zur Folge, dass das verfügbare Volumen für die Montage-, Verbindungs- und Fügetechnik entsprechend geringer wird. Mit konventionellen Verbindungstechnologien wie Verschraubungen, Nietungen oder Klemmverbindungen wird die Konstruktion und die Montage bzw. Demontage solcher miniaturisierter Geräte immer schwieriger.

Aufgabe der vorliegenden Erfindung ist es deshalb, für die Montagetechnik insbesondere solcher miniaturisierter Geräte ein Montagemittel anzugeben, das einen Zusammenbau und/oder eine Demontage von mindestens zwei Einzelteilen eines Gerätes auch an unzugänglichen und/oder miniaturisierten Verbindungsstellen erleichtert. Dabei soll das Montagemittel im montierten Zustand des Gerätes eine mechanische Verbindung zwischen den mindestens zu verbindenden Einzelteilen gewährleisten.

Diese Aufgabe wird erfindungsgemäß dadurch gelöst, dass das Montagemittel mindestens ein Memory-Metall-Element enthält oder durch dieses gebildet ist, welches im Montagezustand bzw. in der Montagephase ( = Phase des Gerätezusammenbaus ) des Gerätes eine erste Gestalt hat und das im montierten Zustand des Gerätes eine zweite, die mechanische Verbindung zwischen den Geräteeinzelteilen gewährleistende Gestalt aufweist, die vor der Montage des Gerätes dem Memory-Metall-Element unter Ausnutzung seiner Memory-Eigenschaft eingeprägt wurde. Unter einer mechanischen Verbindung wird hierbei ein beliebiger Formschluss zwischen jedem der zu verbindenden Geräteeinzelteile mit dem mindestens einen Memory-Metall-Element verstanden.

Die mit dieser Ausgestaltung der Erfindung verbundenen Vorteile sind insbesondere darin zu sehen, dass durch maßgeschneiderte anwendungsspezifische Materialeigenschaften die Anforderungen an verschiedene Lebensphasen des Gerätes erfüllt werden können, wobei durch den Einsatz mindestens eines Elementes,mit Memory-Eigenschaft Funktionen wie Optimierung des Abstandes oder Dämpfung von Schwingungen in das Element integriert werden können. Anstatt aufwendiger Abstandshalter und/oder schwer zugänglicher Schraub-/Niet-/Klemm-/ oder Schnapp-Verbindungen, die alle in der Montagetechnik zusätzliche Prozessschritte erfordern, wird durch die erfindungsgemäße Verwendung von Memory-Metall-Elementen nach der Montage der gewünschte Form- und gegebenenfalls auch ein Kraftschluss auf einfache Weise gewährleistet, indem die zweite Gestalt unter Zugrundelegung des Memory-Effektes eingestellt wird. Dieses Einstellen der zweiten Gestalt geschieht in an sich bekannter Weise, d.h. im Allgemeinen durch eine gezielte Temperaturbehandlung.

Vorteilhafte Ausgestaltungen des erfindungsgemäßen Montagemittels gehen aus den abhängigen Ansprüchen hervor.

So kann besonders vorteilhaft im Montagezustand des Gerätes die mechanische Verbindung über das mindestens eine Memory-Metall-Element zugleich eine elektrische Verbindung und/oder eine wärmeleitende Verbindung sein. Gerade in hochminiaturisierten Geräten sind nämlich Maßnahmen zur Kontaktierung und insbesondere zu einer Wärmeableitung an vergleichsweise größere Wärmeaustauschflächen von großer Bedeutung. Mit dem erfindungsgemäßen Montagemittel sind entsprechende Anforderungen auf einfache Weise zu erfüllen.

Weiterhin ist es als vorteilhaft anzusehen, wenn das mindestens eine Element mit der Memory-Eigenschaft die Form einer Feder, eines Streifens, eines Bolzens oder einer Niete hat. Bauteile mit solchen applikationsspezifischen Formen können vorteilhaft zwischen den zu verbindenden Einzelteilen auch auf geringem Raum platziert werden.

Dabei kann vorteilhaft das Memory-Metall-Element mit einem der zu verbindenden Geräteeinzelteile starr verbunden, beispielsweise an dieses angelötet sein. Derartige Lötverbindungen lassen sich vorteilhaft gleichzeitig mit einem Verlöten von weiteren Bauteilen des Gerätes bzw. eines Geräteeinzelteiles vornehmen. Dies, ist insbesondere bei stark miniaturisierten Geräten von besonderem Vorteil.

Darüber hinaus ist es als vorteilhaft anzusehen, wenn zur Demontage des Gerätes zumindest ein Kraftschluss zwischen dem Memory-Metall-Element und wenigstens einem der Geräteeinzelteile durch räumliche Trennung eines der Einzelteile von dem Element aufzuheben ist. Da der Form- und/oder Kraftschluss zwischen dem Element und dem zu verbindenden Einzelteil im Allgemeinen nur durch ein Anliegen des Element an diesem Einzelteil unter Ausübung einer wenn auch gegebenenfalls nur geringen Presskraft erfolgt, ist eine einfache Demontage möglich, ohne dass dieses Einzelteil beschädigt oder zerstört werden müsste. Auf diese Weise ist auch eine Wiederverwendung wertvoller Einzelteile und/oder der Elemente mit Memory-Eigenschaft für gleiche oder ähnliche Anwendungszwecke möglich. Auch ist so die Demontage bzw. Selbstzerlegung ohne mechanischen Eingriff bezüglich der Verbindung zwischen dem Element mit Memory-Eigenschaft und dem trennbaren Einzelteil eröffnet.

Vorzugsweise lässt sich das mindestens eine Memory-Metall-Element als Beabstandungsvorrichtung zwischen zwei Geräteeinzelteilen vorsehen. Die Geräteeinzelteile brauchen dann nämlich bei einer Gerätemontage , beispielweise innerhalb eines Gehäuses, nur locker aneinandergefügt oder aufeinandergelegt zu werden; eine endgültige Positionierung innerhalb des Gerätes erfolgt dann mittels der Aktivierung der zweiten Gestalt des jeweiligen Memory-Metall-Elementes.

Es ist aber auch möglich, das mindestens eine Memory-Metall-Element als eine Klemmvorrichtung auszuführen, über die eine Klemmverbindung zwischen den zu verbindenden Geräteeinzelteilen zu schaffen ist.

Zur Aktivierung der zweiten Gestalt des mindestens einen Memory-Metall-Elementes kann diesem ein Heizmittel zugeordnet sein. Dabei kann es sich vorteilhaft um einen Heizstrom durch das jeweilige Memory-Metall-Element oder um eine Heizvorrichtung außerhalb des Memory-Metall-Elementes handeln. Die Aktivierung mehrerer Memory-Metall-Elemente braucht dabei nicht unbedingt gleichzeitig zu erfolgen.

Das mindestens eine Memory-Metall-Element kann vorteilhaft zumindest teilweise aus einer TiNi- oder NiMn- oder CuAl-Legierung bestehen, wobei gegebenenfalls noch mindestens ein weiterer Legierungspartner vorhanden ist. Die hervorragende Korrosionsbeständigkeit der vorgenannten Materialien stellt eine besondere Eigenschaft dar, die einen Einsatz der erfindungsgemäßen Elemente in einem mobilen Fahrzeug wie z.B. in einem Automobil oder einen anderen dezentralen, mobilen Einsatz auch in einer umgebungsbelasteten Atmosphäre ermöglicht. Auch eine Fertigung in einer solchen Atmosphäre wird so eröffnet.

Weitere vorteilhafte Ausgestaltungen des erfindungsgemäßen Verbindungsmittels gehen aus den übrigen Ansprüchen hervor.

Zur weiteren Erläuterung der Erfindung wird nachfolgend auf die Zeichnung Bezug genommen, in der eine vorteilhafte Ausführungsform eines Gerätes mit erfindungsgemäßen Montagemitteln schematisch veranschaulicht ist. Es zeigen jeweils in Schrägansicht deren Figuren 1 und 2 zwei verschiedene Montagezustände eines entsprechenden elektronischen Gerätes und deren Figur 3 eine Demontagemöglichkeit dieses Gerätes. Dabei sind in den Figuren sich entsprechende Teile mit denselben Bezugszeichen versehen. ,

Mit erfindungsgemäßen Memory-Metall-Elementen ist eine form- und gegebenenfalls auch kraftschlüssige, im Allgemeinen zumindest teilweise lösbare Verbindung zu oder zwischen Einzelteilen eines Gerätes vorzugsweise der Elektronik zu schaffen. Bei dem Gerät kann es sich insbesondere um eine Vorrichtung mit hohem Integrationsgrad ihrer Bauteile wie z.B. um ein Handy, ein Notebook oder eine Steuerungselektronik für die Automatisierungstechnik oder Automobiltechnik handeln. Solche Geräte weisen im Allgemeinen mehrere Geräteeinzelteile wie Flachbaugruppen oder Schaltungsträger, Abschirmbleche oder - folien auf, zwischen denen bei einer Montage ( = bei einem Zusammenfügen der Einzelteile ) eine mechanische Verbindung zu schaffen ist. An solche Verbindungen werden häufig noch spezielle Forderungen gestellt wie z.B. ein exakter Abstand und/oder eine Wärmeabfuhr der Geräteeinzelteile untereinander oder bzgl. weiterer Geräteeinzelteile wie z.B. Metallrahmen oder Abschirmbleche oder -folien. Ein entsprechendes elektronisches Gerät ist dem Ausführungsbeispiel der Figuren zu Grunde gelegt.

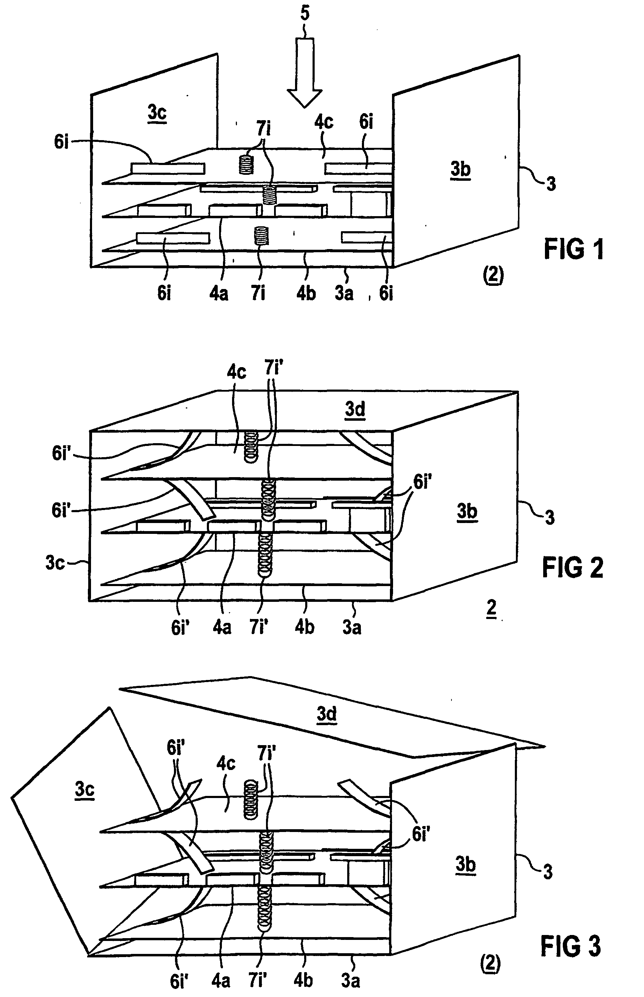

Figur 1 zeigt den Montagezustand (= Zusammenbauvorgang - bzw. -phase) eines solchen, allgemein mit 2 bezeichneten Gerätes. Dieses Gerät hat einen Bodenteil 3a eines Gehäuses 3 sowie zwei davon seitlich angebrachte Seitenteile 3b und 3c. Diese beispielsweise aus Al- oder Stahlblech oder Kunststoffmaterial wie ABS bestehenden Gehäuseteile stellen eine Basis-Gehäuseeinheit dar, die von ihrer nach oben offenen Seite her mit flachen Einzelteilen bestückt werden soll. Bei diesen Einzelteilen kann es sich vorzugsweise um Schaltungsträger bzw. Flachbaugruppen handeln, die mit diversen Bauelementen der Elektronik bestückt sind. Für das Ausführungsbeispiel sei eine Baugruppenplatine 4a angenommen. Ebensogut kann es sich bei diesen Einzelteilen um Abschirmbleche oder -folien handeln, von denen für das Ausführungsbeispiel zwei Abschirmplatten 4b und 4c zu,beiden (Flach-)Seiten der Platine 4a angenommen sind. Die flächenhafte Ausdehnung dieser Einzelteile 4a bis 4c ist an die des Gehäusebodenteils 3a angepasst. Ihre Stapelung innerhalb der Gehäuseeinheit aus den Teilen 3a bis 3c erfolgt, in definierter Reihenfolge ohne Arretierung oder Befestigung in der gewählten Montage- oder Bestückungsrichtung, die durch einen Pfeil 5 veranschaulicht ist. An zumindest einigen der Platten, im Ausführungsbeispiel an den Abschirmplatten 4b und 4c, sind streifenförmige Memory-Metall-Elemente 6i und federartige Memory-Metall-Elemente 7i angebracht, beispielsweise an der Oberseite der unteren Abschirmplatte 4b sowie an der Unter- und Oberseite der oberen Abschirmplatte 4c angelötet. Die Memory-Metall-Elemente 6i und 7i haben dabei eine vorbestimmte erste Gestalt bzw. Form, die die Montage nicht behindert. Erst nach der Montage sollen die Memory-Metall-Elemente nicht nur zu einer gegenseitigen Beabstandung der Platten 4a bis 4c untereinander um ein gewünschtes Maß dienen. Vielmehr soll mit ihnen auch eine Fixierung des aus diesen Platten gebildeten Stapels innerhalb des nach der Montage geschlossenen Gehäuses 3 gewährleistet werden. D.h., zumindest in diesem Zustand soll ein Form- und vorzugsweise auch Kraftschluss zwischen dem Plattenstapel 4a bis 4c und dem Gehäuse 3 vorhanden sein.

Nach einem Schließen des Gehäuses 3 mit einem Gehäuse-Deckelteil 3d werden gemäß Figur 2 die Memory-Metall-Elemente 6i und 7i durch eine Wärmebehandlung mit Hilfe eines zugeordneten Heizmittels aktiviert. Eine solche Wärmebehandlung erfolgt im Allgemeinen durch eine externe Temperaturerhöhung oder durch eine Bestromung der Elemente selbst. Die Bestromung kann auch sukzessive für die einzelnen Platten erfolgen. Auf Grund dieser Aktivierung nehmen dann die Memory-Metall-Elemente ihre zweite Gestalt bzw. Form an, die ihnen vor dem Einbau auf der jeweiligen Platte 4b oder 4c in an sich bekannter Weise eingeprägt wurde. In Figur 2 sind die Memory-Metall-Elemente 6i und 7i nach ihrer Aktivierung mit 6i' bzw. 7i' bezeichnet. Wie aus der Figur ersichtlich ist, gewährleistet diese zweite Gestalt der Memory-Metall-Elemente 6i' und 7i' einen Form- und Kraftschluss zwischen jeweils benachbarten Platten 4a bis 4c untereinander und bezüglich des Bodenteils 3a sowie des Deckelteils 3d des Gehäuses 3. D.h., durch die Aktivierung der Elemente ist,eine Selbstjustage der Baugruppenplatine 4a und der Abschirmbleche bzw. -platten 4b und 4c innerhalb des Gehäuses 3 zu erreichen, ohne dass es eines mechanischen'Eingriffs von außen an insbesondere unzugängliqhen Stellen bedarf.

Zur Demontage des mit der Baugruppenplatine 4a und den Abschirmplatten 4b und 4c bestückten Gehäuses 3 wird dieses geöffnet, wobei z.B. der Deckelteil 3d abgehoben wird und die Seitenteile 3b und 3c seitlich weggenommen werden. Dabei wird der Form- und Kraftschluss über die Memory-Metall-Elemente 6i' und 7i' zu diesen Gehäuseteilen aufgehoben; und die einzelnen Platten 4a bis 4c sind nun zur weiteren Verwendung herausnehmbar.

D.h., es ist eine Demontagetiefe z.B. entsprechend gesetzlicher Bestimmungen und für einen Austausch oder eine Nachrüstung von funktionsfähigen Baugruppen ohne zusätzlichen Aufwand nach Öffnen der Gehäuseteile und zerstörungsfrei zu erreichen.

Die Memory-Metall-Elemente 6i und 7i bestehen zumindest teilweise aus einer der bekannten Formgedächtnis-Legierungen. Beispiele solcher Legierungen sind Ti-Ni-Legierungen, wobei die Ti-Komponente als auch die Ni-Komponente die Hauptkomponente bilden und noch weitere Legierungspartner vorhanden sein können. Daneben sind auch Cu-Al-Legierungen mit weiteren Legierungspartnern bekannt, wobei der Anteil der Al-Komponente größer oder kleiner als der des weiteren Legierungspartners sein kann. So gehen z.B. aus "Materials Science and Engineering", Vol. A 202, 1995, Seiten 148 bis 156 verschiedene zusammengesetzte Ti-Ni- und Ti-Ni-Cu-Legierungen hervor. In "Intermetallics", Vol. 3, 1995, Seiten 35 bis 46 und "Scripta METALLURGICA et MATERIALIA", Vol. 27, 1992, Seiten 1097 bis 1102 sind spezielle Ti₅₀Ni₅₀₋ₓPdₓ-Formgedächtnis-Legierungen beschrieben. Statt der Ti-Ni-Legierungen sind selbstverständlich auch andere Formgedächtnis-Legierungen geeignet. So kommen beispielsweise Cu-Al-Formgedächtnis-Legierungen in Frage. Eine entsprechende CuZn24A13-Legierung ist aus "Z. Metallkde.", Bd. 79, H. 10, 1988, Seiten 678 bis 683 zu entnehmen. In "Scripta Materialia", Vol. 34, No. 2, 1996, Seiten 255 bis 260 ist,eine weitere Cu-Al-Ni-Formgedächtnis-Legierung beschrieben. Zu den vorerwähnten binären oder ternären Legierungen können in an sich bekahnter Weise noch weitere Legierungspartner wie z.B. Hf, Pd, Au, Pt, Cr oder gegebenenfalls Ti hinzulegiert sein. Beispielsweise liegt der Anteil dieser mindestens einen weiteren Komponente unter 5 Atom-% . Er kann jedoch auch davon stärker abweichen. Weitere mögliche Legierungspartner verschiedener binärer Memory-Metalle, unter anderem auch für Ni-Mn-Legierungen, sind in "Transactions of the ASME", Vol. 121, Jan. 1999, Seiten 98 bis 101 genannt.

Für das vorstehend erläuterte Ausführungsbeispiel sei eine Ni-Ti-Nb-Formgedächtnis-Legierung ausgewählt. Entsprechende Legierungen sind kommerziell erhältlich und besitzen beispielsweise auf Grund ihres Herstellungsprozesses folgende Eigenschaften:
Austenit-Temperatur: >+50°C;
Martensit-Temperatur: <-50°C.

Dabei sind in Abhängigkeit vom Herstellungsprozess Hysteresebreiten zwischen -150°C und +100°C erreichbar. Einem entsprechenden Memory-Metall-Element wird bei einer vorbestimmten Hochtemperatur von mehreren hundert °C eine gewünschte Hochtemperaturform eingeprägt, die als zweite Gestalt des Elementes angesehen werden kann. Bei Abkühlung auf Raumtemperatur wird diese zweite Gestalt in eine Ausgangsform überführt (= erste Gestalt; vgl. Fig. 1). Diese Ausgangsform des Memory-Metall-Elementes ist bei der Montage des Gerätes zu Grunde gelegt. Erwärmt man nun das Element bzw. ein mit ihm verbundenes Abschirmblech oder eine andere Komponente auf eine Temperatur oberhalb der Austenit-Temperatur des Memory-Metalls, beispielweise auf 60 bis 80°C, so nimmt das Element die ihm eingeprägte Hochtemperaturform (= zweite Gestalt; vgl. Fig.2) an. Diese zweite Gestalt bleibt auch bei einer Wiederabkühlung auf Raumtemperatur erhalten und kann erst auf Grund der Hystereseeigenschaft des besonderen Metalls bei tieferen Temperaturen (unterhalb der Martensit-Temperatur) rückgängig gemacht werden.

Verwendbar für die erfindungsgemäßen Elemente (6i, 7i) sind Memory-Metalle nach dem sogenannten Ein-Weg-Effekt oder dem sogenannten Zwei-Wege-Effekt. Ein Element mit Ein-Weg-Effekt seines Memory-Metalls kann sich bei Überschreiten der Austenit-Umwandlungstemperatur, die z.B. bei 60° bis 80°C liegt, an seine ihm bei sehr hoher Temperatur von beispielsweise etwa 800°C eingeprägte Hochtemperaturform erinnern. Diese Hochtemperaturform bleibt dann auch bei einer Abkühlung auf eine beliebig tiefere Temperatur, z.B. auf Raumtemperatur oder darunter erhalten. Ein solches Ein-Weg-Effekt-Element lässt sich jedoch in einem Tieftemperaturzustand, insbesondere unterhalb der Martensit-Umwandlungstemperatur, von einem anderen Aktor wie z.B. einer üblichen Feder verformen. Bei einer Erwärmung nimmt es jedoch die ihm eingeprägte Hochtemperaturform wieder an. Auch ein Element mit Zwei-Wege-Effekt seines Memory-Metalls findet bei Erwärmung in die ihm bei sehr hoher Temperatur eingeprägte Hochtemperaturform. Durch ein Training, z.B. durch eine 20 bis 200-mal erfolgte Verformung im demgegenüber kälteren (= nicht erwärmten bzw. wieder abgekühlten) Zustand, nimmt dann das Memory-Metall bei einer Abkühlung in die sogenannte Martensit-Phase die ihm antrainierte Form an. Dies führt dazu, dass sich ein solches Zwei-Wege-Effekt-Element in Abhängigkeit von der Temperatur unterschiedlich verformt, nämlich in eine Hochtemperaturform (z.B. bei einer Erwärmung über 80°C) oder in eine Tieftemperaturform (z.B. bei einer Abkühlung unter -20°C). D.h., je nach Temperatur findet das Zwei-Wege-Effekt-Element automatisch in die aufgeprägte Hochtemperaturform oder die antrainierte Tieftemperaturform.

Beide Typen von Metallen sind für die erfindungsgemäßen Elemente verwendbar, insbesondere wenn zur Demontage das Gehäuse geöffnet wird, so dass die einzelnen Baugruppen, Platinen und Bleche dann jeweils frei liegen. Materialien mit einem Ein-Weg-Effekt haben einen Kostenvorteil. Elemente aus einem Material vom Zwei-Wege-Typ hingegen nehmen bei einer starken Abkühlung ihre Ausgangsform (= erste Gestalt) an und heben so auch ohne Zerlegung eines Gehäuses einen Kraftschluss ihres montierten Zustandes auf.

## Patentansprüche

1. Montagemittel für zwei Einzelteile eines Gerätes der Elektronik, wobei das Montagemittel zumindest im montierten Zustand des Gerätes mit den beiden Geräteeinzelteilen mechanisch verbunden ist, **dadurch gekennzeichnet, dass** das Montagemittel mindestens ein Memory-Metall-Element (6i, 7i) enthält oder durch dieses gebildet ist, welches
- im Montagezustand des Gerätes (2) eine erste Gestalt hat und
- im montierten Zustand des Gerätes eine zweite, die mechanische Verbindung zwischen den Geräteeinzelteilen (3a-3d, 4a-4c) gewährleistende Gestalt aufweist, die vor der Montage des Gerätes dem Memory-Metall-Element unter Ausnutzung seiner Memory-Eigenschaft eingeprägt wurde.

2. Montagemittel nach Anspruch 1, **dadurch gekennzeichnet, dass** im montierten Zustand des Gerätes zwischen den Einzelteilen über das mindestens eine Memory-Metall-Element ein Kraftschluss hervorgerufen ist.

3. Montagemittel nach Anspruch 1 oder 2, **dadurch gekennzeichnet, dass** im Montagezustand des Gerätes die mechanische Verbindung über das mindestens eine Memory-Metall-Element (6i) zugleich eine elektrische Verbindung und/oder eine wärmeleitende Verbindung ist.

4. Montagemittel nach einem der vorangehenden Ansprüche, **gekennzeichnet durch** eine im Demontagezustand des Gerätes (2) aufgehobene mechanische Verbindung zwischen dem Memory-Metall-Element (6i', 7i') und wenigstens einem der Geräteeinzelteile (4a bis 4d, 3a bis 3c).

5. Montagemittel nach einem der vorangehenden Ansprüche, **dadurch gekennzeichnet, dass** das mindestens eine Memory-Metall-Element (6i, 7i) die Form einer Feder, eines Streifens, eines Bolzens oder einer Niete hat.

6. Montagemittel nach einem der vorangehenden Ansprüche, **dadurch gekennzeichnet, dass** das mindestens eine Memory-Metall-Element (6i, 7i) mit einem der zu verbindenden Geräteeinzelteile starr verbunden ist.

7. Montagemittel nach Anspruch 6, **dadurch gekennzeichnet, dass** das mindestens eine Memory-Metall-Element (6i, 7i) an dem einen Geräteeinzelteil angelötet ist.

8. Montagemittel nach einem der vorangehenden Ansprüche, **gekennzeichnet durch** mindestens ein Memory-Metall-Element (6i, 7i) aus einer TiNi- oder NiMn- oder CuAl-Legierung, die gegebenenfalls noch mindestens einen weiteren Legierungspartner enthält.

9. Montagemittel nach einem der vorangehenden Ansprüche, **dadurch gekennzeichnet, dass** sein mindestens eines Memory-Metall-Element (6i, 7i) vom Ein- oder Zwei-Wege-Typ ist.

10. Montagemittel nach einem der vorangehenden Ansprüche, **dadurch gekennzeichnet, dass** sein mindestens ein Memory-Metall-Element (6i, 7i) als Beabstandungsvorrichtung vorgesehen ist.

11. Montagemittel nach einem der Ansprüche 1 bis 9, **dadurch gekennzeichnet, dass** sein mindestens ein Memory-Metall-Element als Klemmvorrichtung vorgesehen ist.

12. Montagemittel nach einem der vorangehenden Ansprüche, **dadurch gekennzeichnet, dass** seinem mindestens einen Memory-Metall-Element (6i, 7i) Heizmittel zugeordnet sind.

13. Montagemittel nach Anspruch 12, **dadurch gekennzeichnet, dass** als Heizmittel ein Heizstrom durch das mindestens eine Memory-Metall-Element (6i, 7i) oder eine Heizvorrichtung außerhalb des Memory-Metall-Elementes vorgesehen ist.

## Claims

1. Assembly means for two individual parts of an electronics device, the assembly means, at least in the assembled state of the device, being mechanically connected to the two individual parts of the device, **characterized in that** the assembly means includes or is formed by at least one memory metal element (6i, 7i) which
- in the assembly state of the device (2) takes a first form, and
- in the assembled state of the device takes a second form, which is responsible for ensuring the mechanical connection between the individual parts (3a-3d, 4a-4c) of the device and which has been imparted to the memory metal element, making use of its memory property, prior to assembly of the device.

2. Assembly means according to Claim 1, **characterized in that** in the assembled state of the device a non-positive lock is produced between the individual parts by means of the at least one memory metal element.

3. Assembly means according to Claim 1 or 2,
**characterized in that**, in the assembly state of the device, the mechanical connection produced by means of at least one memory metal element (6i) is at the same time an electrical connection and/or a thermally conductive connection.

4. Assembly means according to one of the preceding claims, **characterized by** a mechanical connection between the memory metal element (6i', 7i') and at least one of the individual parts (4a to 4d, 3a to 3c) of the device which is eliminated in the dismantled state of the device (2).

5. Assembly means according to one of the preceding claims, **characterized in that** the at least one memory metal element (6i, 7i) is in the form of a spring, a strip, a bolt or a rivet.

6. Assembly means according to one of the preceding claims, **characterized in that** the at least one memory metal element (6i, 7i) is rigidly connected to one of the individual parts of the device which are to be connected.

7. Assembly means according to Claim 6, **characterized in that** the at least one memory metal element (6i, 7i) is soldered to said individual part of the device.

8. Assembly means according to one of the preceding claims, **characterized by** at least one memory metal element (6i, 7i) made from a TiNi or NiMn or CuAl alloy, which if appropriate may also contain at least one further alloying partner.

9. Assembly means according to one of the preceding claims, **characterized in that** its at least one memory metal element (6i, 7i) is of the one-way or two-way type.

10. Assembly means according to one of the preceding claims, **characterized in that** its at least one memory metal element (6i, 7i) is provided as a spacer feature.

11. Assembly means according to one of Claims 1 to 9, **characterized in that** its at least one memory metal element is provided as a clamping feature.

12. Assembly means according to one of the preceding claims, **characterized in that** its at least one memory metal element (6i, 7i) is assigned heating means.

13. Assembly means according to Claim 12,
**characterized in that** the heating means provided is a heating current passing through the at least one memory metal element (6i, 7i) or a heating device outside the memory metal element.

## Revendications

1. Moyen de montage de deux parties d'un appareil de l'électronique, le moyen de montage étant assemblé mécaniquement au moins à l'état monté de l'appareil aux deux parties de l'appareil, **caractérisé en ce qu'**il comporte au moins un élément (6i, 7i) de métal à mémoire ou en est formé, lequel
- a une première forme à l'état de montage de l'appareil (2) ; et
- a, à l'état monté de l'appareil, une deuxième forme assurant l'assemblage mécanique entre les parties (3a à 3d, 4a à 4c) de l'appareil, forme qui a été imprimée avant le montage de l'appareil à l'élément en métal à mémoire en tirant partie de sa propriété de mémoire.

2. Moyen de montage suivant la revendication 1, **caractérisé en ce qu'**à l'état monté de l'appareil il est provoqué une coopération de force entre les parties par l'intermédiaire du au moins un élément en métal à mémoire.

3. Moyen de montage suivant la revendication 1 ou 2, **caractérisé en ce qu'**à l'état de montage de l'appareil, l'assemblage mécanique par l'intermédiaire du au moins un élément (6i) en métal à mémoire est en même temps une liaison électrique et/ou une liaison conductrice de la chaleur.

4. Moyen de montage suivant l'une des revendications précédentes, **caractérisé par** un assemblage mécanique levé à l'état de démontage de l'appareil (2), entre l'élément (6i', 7i') en métal à mémoire et au moins l'une des parties (4a à 4d, 3a à 3c) de l'appareil.

5. Moyen de montage suivant l'une des revendications précédentes, **caractérisé en ce qu'**au moins un élément (6i, 7i) en métal à moire a la forme d'un ressort, d'une bande, d'un axe ou d'un rivet.

6. Moyen de montage suivant l'une des revendications précédentes, **caractérisé en ce qu'**au moins un élément (6i, 7i) en métal à mémoire est relié rigidement à une partie de l'appareil à assembler.

7. Moyen de montage suivant la revendication 6, **caractérisé en ce qu'**au moins un élément (6i, 7i) en métal à mémoire est brasé à la partie de fa partie de l'appareil.

8. Moyen de montage suivant l'une des revendications précédentes, **caractérisé par** au moins un élément (6i, 7i) en métal à mémoire en un alliage de TiNi ou de NiMn ou de CuAl qui renferme, le cas échéant, encore au moins un autre partenaire d'alliage.

9. Moyen de montage suivant l'une des revendications précédentes, **caractérisé en ce que** son au moins un élément (6i, 7i) en métal à mémoire est du type à un effet ou à deux effets.

10. Moyen de montage suivant l'une des revendications précédentes, **caractérisé en ce que** son au moins un élément (6i, 7i) en métal à mémoire est prévu en tant que dispositif d'entretoisement.

11. Moyen de montage suivant l'une des revendications précédentes, **caractérisé en ce qu'**au moins un élément en métal à mémoire est prévu en tant que dispositif de serrage.

12. Moyen de montage suivant l'une quelconque des revendications précédentes, **caractérisé en ce que** des moyens de chauffage sont associés à son au moins un élément (6i, 7i) en métal à mémoire.

13. Moyen de montage suivant la revendication 12, **caractérisé en ce qu'**il est prévu comme moyen de chauffage un courant électrique de chauffage passant dans le au moins un élément (6i, 7i) en métal à mémoire ou un dispositif de chauffage à l'extérieur de l'élément en métal à mémoire.
